# EUROPEAN PATENT APPLICATION

(11) **EP 2 542 038 A1**
(43) Date of publication of application: **02.01.2013**
(21) Application number: 11744526.2
(22) Date of filing: 04.02.2011
(51) Int. Cl.: H05K 3/06, C23F 1/02, H05K 1/09

(54) **METHOD OF FORMING CIRCUITS UPON FLEXIBLE LAMINATE SUBSTRATE**

(30) Priority: 22.02.2010 JP 2010035863
(71) Applicant: JX Nippon Mining & Metals Corporation, Tokyo 100-8164 (JP)
(72) Inventor: SAKAGUCHI, Kazuhiko, Hitachi-city Ibaraki 317-0056 (JP); INAZUMI, Hajime, Hitachi-city Ibaraki 317-0056 (JP)
(74) Representative: Hoarton, Lloyd Douglas Charles
(86) International application number: PCT/JP2011/052340
(87) International publication number: WO 2011/102238

(57) **Abstract**

Disclosed is a method of forming a circuit on a flexible laminate substrate. When forming a circuit using an adhesiveless flexible laminate which includes a polyimide film as the flexible laminate substrate in which at least one surface thereof is subject to plasma treatment, a tie-coat layer A formed on the polyimide film, a metal conductor layer B formed on the tie-coat layer, and a layer C which has the same components as the tie-coat layer that was formed on the metal conductor layer, the following method is used. The photoresist is coated on the layer C which has the same components as the tie-coat layer that was formed on the metal conductor layer, the photoresist is exposed and developed, the layer C other than the circuit forming parts thereof is selectively removed in advance via pre-etching, the conductor layer B is thereafter removed by supplemental etching with leaving the circuit portion, and the photoresist of the circuit portion is further removed so as to form the circuit. By forming a tie-coat layer or a metal or alloy that is equivalent to the tie-coat layer on the metal conductor layer of the adhesiveless flexible laminate, simultaneously achieved are the inhibition of side etching, which interferes with the achievement of finer pitches of circuit wiring, and the improvement of linearity of the wiring.

## Description

### TECHNICAL FIELD

The present invention relates to a method of forming a circuit on a flexible laminate substrate used as a packaging material for electronic parts such as flexible printed boards, TAB and COF.

### BACKGROUND ART

An FCCL (Flexible Copper Clad Laminate), in which metal conductor layers primarily formed from copper are laminated on a polyimide film, is broadly used as a circuit board material in the electronics industry. Among the above, an adhesiveless flexible laminate substrate (particularly a two-layer flexible laminate) that does not include an adhesive layer between a polyimide film and a metal layer is attracting attention pursuant to the demands of finer pitches of the circuit wiring width.

As a method of producing an adhesiveless flexible laminate substrate which is particularly capable of accommodating fine pitches, is primarily performed by a so-called 'metalizing method': the method of forming, in advance, a metal layer by a__ drying method such as sputtering, CVD, or vapor deposition; and thereafter forming a metal layer film to become the conductor layer by way of wet process plating.
In this metalizing method, in order to increase the adhesion between the metal layer and the polyimide film, modification is carried out by performing plasma treatment to the polyimide film surface in order to eliminate the contaminants on the surface and to improve the surface roughness prior to forming the metal layer (refer to Patent Document 1 and Patent Document 2).

While this method is extremely effective, it has become known that there is a problem in the deterioration of adhesion in terms of long term reliability due to the heat treatment during circuit formation or the usage environment. Thus, additionally proposed was forming a tie-coat layer as an intermediate layer on a plasma-treated surface for increasing the adhesiveness between the polyimide film layer and the metal conductor layer. The foregoing formation of a tie-coat layer is an extremely effective method (refer to Patent Document 1).

Meanwhile, with FCCL that is used in TAB, COF, FPC and the like, the metal conductor layer is etched and removed via the subtractive process. Pursuant to even finer pitches of the circuit wiring width, improving the etch factor to the finer pitches is being considered, specifically by applying the semi-additive process, and by performing anisotropic etching with added inhibitor in the etching solution for etching the metal conductor layer (refer to Patent Documents 3 and 4).

In the case of the semi-additive process, it is not possible to directly apply the processes that were used in a conventional subtractive process. It is necessary to perform the plating process for newly forming a metal conductor layer, and in addition, a resist is required that corresponds to the thickness of the metal conductor layer.
An etching solution containing an inhibitor can be applied to a conventional etching line; however, it is unable to resolve the problems: the various circuit wiring widths existing in the same substrate are of different shapes and the linearity of the wiring is inferior due to the thickness of the metal conductor layer or the circuit wiring pitch.

Namely, the problem is that the circuit does not become the intended width when etching and forming the circuit in the process of printing a circuit via the resist application and exposure process for forming the intended circuit and additionally performing etching treatment for removing the unwanted portion of the copper foil.
This is caused by the copper circuit formed by etching being etched downward from the surface of the copper layer; that is, etched in a manner of spreading out wide toward the resin layer, which is hereinafter referred to as "sagging" . When considerable "sagging" occurs, the copper circuit may short-circuit near the resin substrate, and become defective in certain cases.

It is necessary to reduce the "sagging" as much as possible. In order to prevent the short-circuit of the copper circuit near the resin substrate, extending the etching time to perform more etching and reduce the "sagging" was considered.
In the foregoing case, however, if there is a location that has already reached a predetermined width dimension, there is a problem in that such location will be further etched and caused the circuit width to be narrower by that much, and the uniform line width (circuit width) that is intended in the circuit design cannot be obtained. In particular, there is a problem in that such location (thinned portion) will generate heat and even break.
While the finer patterns of an electronic circuit are being achieved, the foregoing problem of defects caused by etching still arises even today, which is a major problem in terms of circuit formation.

[Patent Document 1] Japanese Patent No.3173511
[Patent Document 2] Published Patent Application, Japanese Translation of PCT International Application No.2003-519901
[Patent Document 3] Japanese Unexamined Patent Application Publication No.2004-256901
[Patent Document4] Japanese Unexamined Patent Application Publication No.2009-167459

### SUMMARY OF THE INENTION

### [Problems to be Solved by the Invention]

An object of this invention is to provide a method of forming a circuit having favorable wiring linearity while simultaneously inhibiting side etching, which interferes with the achievement of finer pitches of the circuit wiring. The object is achieved by forming a tie-coat layer of the flexible laminate or forming a metal or alloy that is equivalent to the tie-coat layer on a metal conductor layer.

### [Means for Solving the Problems]

In order to achieve the foregoing object, the present invention provides:
1) A method of forming a circuit on a flexible laminate substrate, wherein, when forming a circuit using an adhesiveless flexible laminate which includes a polyimide film as the flexible laminate substrate in which at least one surface thereof is subject to plasma treatment, a tie-coat layer A formed on the polyimide film, a metal conductor layer B formed on the tie-coat layer, and a metal or alloy layer C, which has a lower etching rate than that of copper, formed on the metal conductor layer, photoresist is coated on the metal or alloy layer C, which has a lower etching rate than that of copper, formed on the metal conductor layer, the photoresist is exposed and developed, the layer C other than the circuit forming parts thereof is selectively removed in advance via pre-etching, the conductor layer B is thereafter removed by supplemental etching with leaving the circuit portion, and the photoresist of the circuit portion is further removed so as to form the circuit.

The present invention additionally provides:
2) The method of forming a circuit on a flexible laminate substrate according to 1) above, wherein the layer C formed on the metal conductor layer is a sputter layer selected from one type among nickel, chromium, cobalt, nickel alloy, chromium alloy, and cobalt alloy having a thickness of 1 to 50 nm;
3) The method of forming a circuit on a flexible laminate substrate according to 1) or 2) above, wherein the layer C formed on the metal conductor layer has the same components as the tie-coat layer A;
4) The method of forming a circuit on a flexible laminate substrate according to any one of 1) to 3) above, wherein the tie-coat layer A is a sputter layer selected from one type among nickel, chromium, cobalt, nickel alloy, chromium alloy, and cobalt alloy having a thickness of 5 to 100 nm; and
5) The method of forming a circuit on a flexible laminate substrate according to any one of 1) to 4) above, wherein the metal conductor layer B is copper or copper alloy.

### [Effect of the Invention]

An adhesiveless flexible laminate in which a tie-coat layer A or an equivalent layer C formed above and under a metal conductor layer B yields a superior effect. The effect, on the tie-coat layer A side is of being able to improve the adhesion between the polyimide film and the metal layer after thermal aging, whereas on the upper surface side of the metal conductor layer, the effect is of being able to inhibit the side etching when forming a circuit, thus to achieve a high etch factor. The tie-coat layer A or an equivalent layer C, specifically, is selected from one type among nickel, chromium, cobalt, nickel alloy, chromium alloy, and cobalt alloy.
When forming a circuit by etching the metal conductor layer B of the flexible laminate substrate based on the forgoing configuration, it is possible to prevent the occurrence of sagging in the etching process and shorten the time to form a circuit via etching.
In addition, a superior effect of improvement of the linearity of the wiring can be yielded, prior to etching the metal conductor layer B, by way of removing the metal layer, which has a lower etching rate than that of copper, formed immediately above the metal conductor layer B to be etched; specifically, the tie-coat layer A or the equivalent layer (sputter layer) C.
Thus, the present invention yields an effect of providing an adhesiveless flexible laminate for use in electronic circuits in which a circuit with an even more uniform intended circuit width can be formed, etching properties in pattern etching can be improved, and occurrence of short circuits and defective circuit widths be prevented.

### BRIEF DESCRIPTION OF THE DRAWINGS

Fig. 1 is an explanatory diagram showing the cross section of an adhesiveless flexible laminate comprising a polyimide film, a tie-coat layer A, a metal conductor layer B and a sputter layer C.
Fig. 2 is an explanatory diagram showing the calculation method of the etch factor.
Fig. 3 is an explanatory diagram showing the processes performed to the adhesiveless flexible laminate; namely, application and exposure/development of the photoresist, pre-etching of the sputter layer, etching of the metal conductive layer, and peeling of the photoresist layer.
Fig. 4 is a diagram showing a state where the width between the circuits of Comparative Example 1 is narrowed.
Fig. 5 is a diagram showing a state of the circuit of Comparative Example 3 where the linearity is subject to disarray.
Fig. 6 is a diagram showing a state of the circuit of Example 2 with superior linearity.

### DETAILED DESCRIPTION OF THE INVENTION

Specific examples of the present invention are now explained. The ensuing explanation is provided to facilitate the understanding of this invention, and the present invention shall in no way be limited thereby. Various modifications and other embodiments shall be included in the present invention as a matter of course.

The adhesiveless flexible laminate of the present invention includes a polyimide film in which at least one surface thereof is subject to plasma treatment, a tie-coat layer A formed on the polyimide film, a metal conductor layer B formed on the tie-coat layer A, and a metal or alloy layer C (layer made from the same components as the tie-coat layer A or an equivalent layer), which has a lower etching rate than that of copper, formed on the metal conductor layer B. By performing plasma treatment to the polyimide film surface, contaminants on the surface are removed and the surface is modified.
The tie-coat layer A refers to an intermediate layer for improving the adhesiveness between the polyimide film layer and the metal conductor layer B. The term "tie-coat layer" is also used in foregoing Patent Document 1 (Japanese Patent No. 3173511), and is well known as a general technical term. The term "tie-coat layer" is also used in this specification as needed.

As the tie-coat layer A, a sputter layer selected from one type among the following may be used: nickel, chromium, cobalt, nickel alloy, chromium alloy, and cobalt alloy having a thickness of 5 to 100 nm. The respective elements are materials capable of improving the adhesiveness between the polyimide film layer and the metal conductor layer B, and can also be etched to obtain the intended circuit design. The tie-coat layer A is a layer having the function of improving the adhesiveness between the polyimide film layer and the metal conductor layer B.
The nickel alloy, chromium alloy, and cobalt alloy are alloys respectively having nickel, chromium, and cobalt as the main component; specifically, contain nickel, chromium, and cobalt in an amount of 50 mass percent or more, and there is no particular limitation in the accessory component. All existing alloys can be applied. The component composition of the target is directly reflected in the thin film that is formed by sputtering, and the same component can be deposited.

The "normal peel strength" is usually used to measure the initial adhesion after lamination between the polyimide film and the metal layer of the adhesiveless flexible laminate in which the tie-coat layer A and the metal conductor layer B are formed on the surface of the polyimide film that was subject to plasma treatment. The normal peel strength is not dependent on the plasma-treated surface roughness when the roughness Rz of the plasma-treated surface is within the range of 2.5 to 20 nm. However, without the tie-coat layer A, the peel strength deteriorates by roughly half.

The appropriate thickness is 5 to 100 nm since the adhesiveness will deteriorate when the thickness is less than 5 nm, and the result will become saturated when the thickness exceeds 100 nm. While the foregoing materials are useful in preparing the adhesiveless flexible laminate, it should be understood that the selection of other materials is not denied by the present invention.
While copper or copper alloy may be used as the metal conductor layer B, the selection of other materials with high conductivity is not denied likewise.

In addition, the present invention is unique with respect to the layer C formed on the metal conductor layer B. As the layer C, such a metal layer may be used that has an etching rate lower than that of copper may be used; specifically used may be a sputter layer selected from one type among nickel, chromium, cobalt, nickel alloy, chromium alloy, and cobalt alloy.
This layer may be arbitrarily selected and applied, and this layer may also be a layer made of the same components as the tie-coat layer A. If a layer having the same components as the tie-coat layer A is used, there are the following advantages in terms of productivity: deposition via sputtering can be performed using the same target, and the same etching conditions as the tie-coat layer can be applied in the etching process when forming the circuit.

While this layer is a layer that may be made of the same components or selected from a similar composition as the tie-coat layer A, its function is considerably different. In other words, while the tie-coat layer A is a layer having the function of improving the adhesiveness between the polyimide film layer and the metal conductor layer B, the layer C formed on the metal conductor layer B is a layer having the functions of inhibiting the side etching of the metal conductor layer B during the formation of the circuit, preventing the occurrence of sagging caused by the etching process, and thereby enabling a high etch factor (described later).
It is extremely important to recognize that a metal layer having a lower etching rate than that of copper, such as a sputter layer selected from one type among nickel, chromium, cobalt, nickel alloy, chromium alloy, and cobalt to be specific, and a layer made of the same components as the tie-coat layer A have a high etch factor. The recognition was discovered for the first time in the present invention. The appropriate thickness of the layer in the foregoing case is 1 to 50 nm since the effect is low when the layer thickness is less than 1 nm, and the effect becomes saturated when the layer thickness exceeds 50 nm.

When producing the adhesiveless flexible laminate of the present invention, at least one surface of the polyimide film is subject to plasma treatment via glow discharge, a tie-coat layer A is thereafter formed thereon via sputtering, a metal conductor layer B is subsequently formed on the sputter layer, and a layer C having a lower etching rate than that of copper and made of the same components as the tie-coat layer A is additionally formed on the metal conductor layer B via sputtering.
Specifically, a tie-coat layer A having a thickness of 5 to 100 nm can be formed on the plasma-treated surface by sputtering a target material selected from one type among nickel, chromium, cobalt, nickel alloy, chromium alloy, and cobalt alloy. And as described above, copper or copper alloy may be used as the metal conductor layer B.

More specifically, when producing the adhesiveless flexible laminate of the present invention, it is possible to form, on the metal conductor layer B, a layer (sputter layer) C having a thickness of 1 to 50 nm and made of the same components as the tie-coat layer A by sputtering a target material selected from one type among nickel, chromium, cobalt, nickel alloy, chromium alloy, and cobalt alloy having a thickness of 1 to 50 nm.
This layer inhibits the side etching of the metal conductor layer B during the formation of the circuit, prevents the occurrence of sagging caused by the etching process, and has a high etch factor.

Photoresist is foremost coated on the upper surface side of the metal conductor layer B, a circuit pattern is thereafter exposed and developed, and then subject to the etching process. Generally speaking, relative to an etching solution such as ferric chloride or copper chloride, the sputter layer C of the present invention is thin at 1 to 50 nm, and, other than the metal or alloy of the sputter layer C itself dissolving, as a result of the etching solution infiltrating the sputter layer, the peeling at the interface of the metal conductor layer B and the sputter layer is promoted, and the sputter layer is removed from the resist opening as a film in the etching process.
In the etching process, it is possible to dissolve, in advance, the sputter layer exposed on the resist opening, and the removal of the sputter layer C with a pre-etching solution that will not corrode the metal conductor layer B and the etching process using an etching solution such as ferric chloride or copper chloride play important roles in maintaining the linearity of the circuit.

With the present invention, the sputter layer C between the resist and the metal conductor layer B inhibits the side etching of the metal conductor layer B caused by the etching solution in the etching process, which consequently enables anisotropic etching. This is the main reason that a high etch factor can be obtained.

### [Examples]

The Examples and Comparative Examples of the present invention are now explained. These Examples are merely illustrative, and the present invention shall in no way be limited thereby. In other words, other embodiments and modes covered by the this invention shall be included in the present invention. Note that the Comparative Examples will also be similarly explained for comparison.

There is no particular limitation in the material to be used as the polyimide film. For instance, Upilex manufactured by Ube Industries, Kapton manufactured by DuPont-Toray, Apical manufactured by Kaneka and the like are commercially available, and the present invention can be applied to any one of these polyimide films. The present invention is not limited to this kind of specific variety. The Examples and Comparative Examples used Upilex-SGA manufactured by Ube Industries as the polyimide film.
Foremost, the polyimide film was placed in a vacuum apparatus and, after evacuation, oxygen was introduced into the chamber, the chamber pressure was adjusted to 10 Pa, and plasma treatment was thereby performed.

Subsequently, via sputtering, a tie-coat layer A with a varied thickness in the range of 0 to 50 nm was formed on the foregoing polyimide film surface that was subject to plasma treatment, and a copper layer of 300 nm was additionally formed thereon. And, by forming a metal conductor layer B (thickness 8.5, 12 µm) made of copper on the foregoing the copper layer formed on the tie-coat layer A via electroplating, an adhesiveless flexible laminate was thereby prepared.
A sputter layer C of 1 to 50 nm was additionally formed on the surface of the metal conductor layer B of the adhesiveless flexible laminate via sputtering.

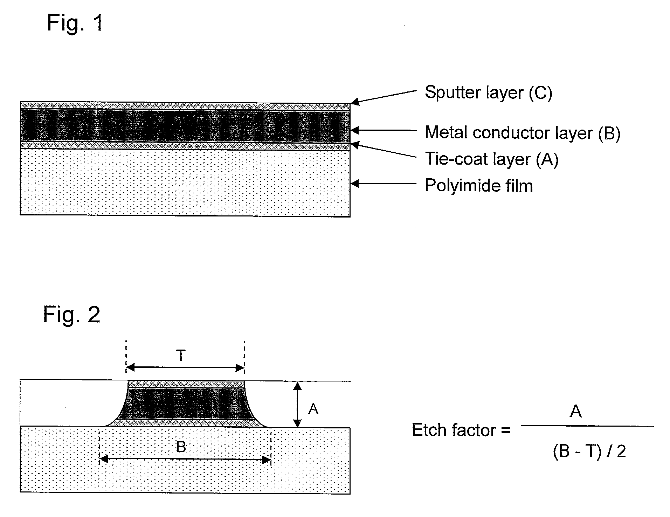

The cross section of the adhesiveless flexible laminate is shown in Fig. 1. As shown, the adhesiveless flexible laminate comprises a polyimide film, a tie-coat layer A, a metal conductor layer B, and a sputter layer C. Next, in order to evaluate the etch factor, samples were prepared. As the samples, used were glass masks of a 40-micrometer pitch to which a liquid resist was coated and dried, and a circuit having a line of 25 micrometers and a space of 15 micrometers was drawn thereon, and the etch factor was evaluated after exposing, developing and drying the samples. In order to selectively etch the sputter layer C prior to the etching process, samples that were subject to pre-etching and samples that were not subject to pre-etching were prepared.

As the selective etching solution, for the nickel alloy, sulfuric acid/hydrochloric acid-based CH series manufactured by Mec, sulfuric acid/hydrochloric acid-based Flicker manufactured by Nihon Kagaku Sangyo, hydrochloric acid-based NR series manufactured by Adeka, organic acid/phosphoric acid/hydrochloric acid-based Seedlon manufactured by Ebara-Udylite and so on are commercially available, and these may be arbitrarily selected and used without any particular limitation.
Flicker manufactured by Nihon Kagaku Sangyo was used in the Examples. By adopting the selective etching process, it was also possible to selectively etch nickel, chromium, cobalt, chromium alloy and cobalt alloy, in addition to nickel alloy, without dissolving the metal conductor layer B.
Moreover, while ferric chloride and copper chloride can be applied to the etching of the metal conductor layer B, ferric chloride (40° Baume 50°C) and copper chloride (2 mol/L, hydrochloric acid 3 mol/L, 50°C) were used in the Examples and the Comparative Examples.

The etch factor can be defined as shown in Fig. 2. As shown, the etch factor can be calculated as A/((B-T)/2).
The evaluation results of the etch factor are shown in Table 1. The etching time differed depending on the sample in order to coordinate the top width (T) of the circuit wiring width to 12±1 micrometers.
Since the side etching will simultaneously occur even when the etching solution that infiltrated from the resist opening having a space of 15 micrometers causes etching to advance toward the bottom, when etching is performed up to a certain level of the top width, samples with a low etch factor will have a large bottom width (B).

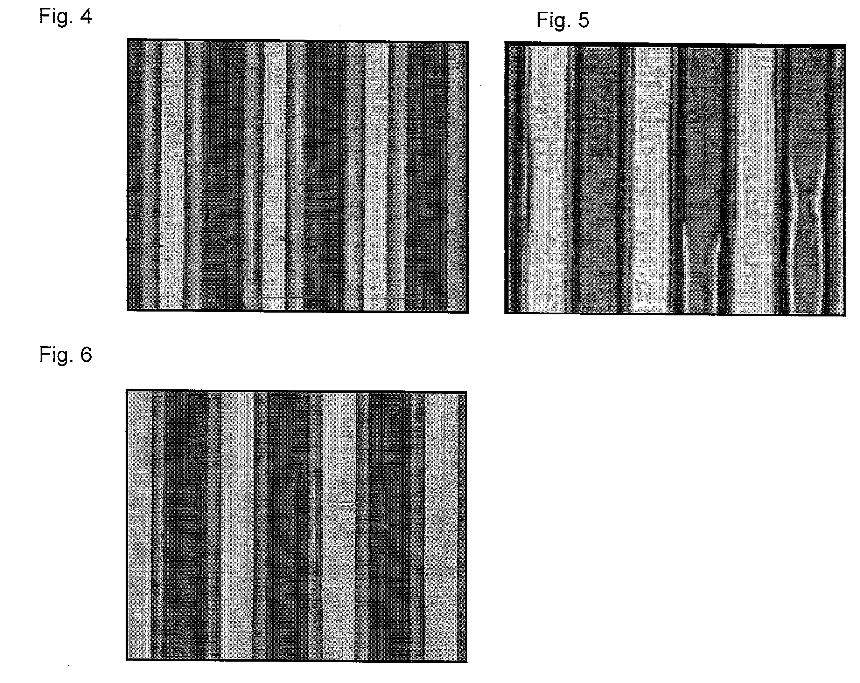

Meanwhile, with the samples in which the side etching was inhibited, the difference between the top width (T) and the bottom width (B) is reduced since etching toward the bottom direction advances preferentially.
Note that the evaluation of the circuit linearity was performed using an optical microscope, and the circuit shape was observed at x100. In the foregoing case, there will be 16 circuits having a 40-micrometer pitch in the observed screen, and narrowed circuits subject to disarray as shown in Fig. 5 were deemed to be defective circuits, and the number of circuits not subject to disarray was measured as the evaluation. Samples that are 16 out of 16 (16/16) can be deemed circuits without any disarray and with favorable linearity.

**[Table 1]**

| | Tie-coat layer type | Sputter layer type | Sputter layer thickness (nm) | Copper thickness (microns) | Pre-etching | Etching solution | T - Top width (microns) | B - Bottom width (microns) | Etch factor | Circuit linearity |
|---|---|---|---|---|---|---|---|---|---|---|
| Comparative Example 1 | NiCr | None | 0 | 8 5 | None | Ferric chloride | 11 3 | 21 4 | 1.69 | 16/16 |
| Comparative Example 2 | NiCr | None | 0 | 8.5 | None | Copper chloride | 11 3 | 20 5 | 1 85 | 16/16 |
| Comparative Example 3 | NiCr | NiCr | 10 | 8 5 | None | Ferric chloride | 11.2 | 16.8 | 3 04 | 8/16 |
| Comparative Example 4 | NiCr | NiCr | 10 | 8.5 | None | Copper chloride | 11.1 | 16 7 | 3 06 | 9/16 |
| Comparative Example 5 | NiCr | NiCr | 30 | 8 5 | None | Ferric chloride | Circuit not formed | Circuit not formed | - | 0/16 |
| Comparative Example 6 | Ni | Ni | 10 | 8.5 | None | Ferric chloride | 11 5 | 17 2 | 2 98 | 7/16 |
| Comparative Example 7 | Ni | Ni | 30 | 8 5 | None | Ferric Chloride | Circuit not formed | Circuit not formed | - | 0/16 |
| Comparative Example 8 | Cr | Cr | 10 | 8.5 | None | Ferric chloride | Circuit not formed | Circuit not formed | - | 0/16 |
| Comparative Example 9 | CoCr | CoCr | 10 | 8.5 | None | Copper chloride | 11.3 | 17 0 | 2.98 | 10/16 |
| Comparative Example 10 | NiCr | NiCr | 10 | 12 | None | Ferric chloride | 11.8 | 20 6 | 1.93 | 2/16 |
| Example 1 | NiCr | NiCr | 3 | 8.5 | None | Ferric chloride | 11.9 | 17 7 | 2.93 | 16/16 |
| Example 2 | NiCr | NiCr | 30 | 8 5 | Performed | Copper chloride | 12.7 | 15.3 | 6 54 | 16/16 |
| Example 3 | NiCr | NiCr | 50 | 8 5 | Performed | Copper chloride | 12 5 | 15.8 | 5 15 | 16/16 |
| Example 4 | Ni | Ni | 10 | 8.5 | Performed | Ferric chloride | 12.0 | 17.2 | 3 27 | 16/16 |
| Example 5 | Cr | Cr | 10 | 8.5 | Performed | Ferric chloride | 12 5 | 16.0 | 4 86 | 16/16 |
| Example 6 | Cr | Cr | 20 | 8 5 | Performed | Ferric chloride | 12 8 | 16.1 | 5 15 | 16/16 |
| Example 7 | Co | Co | 10 | 8.5 | None | Copper chloride | 11 1 | 17 5 | 2.66 | 16/16 |
| Example 8 | Co | Co | 10 | 8.5 | Performed | Copper chloride | 11.6 | 17 3 | 2 98 | 16/16 |
| Example 9 | CoCr | CoCr | 10 | 8 5 | Performed | Copper chloride | 11.5 | 16.9 | 3 15 | 16/16 |
| Example 10 | NiCr | NiCr | 10 | 12 | Performed | Ferric chloride | 12 2 | 20.2 | 2 13 | 16/16 |
| Example 11 | NiCr | Ni | 10 | 8.5 | Performed | Ferric chloride | 11 8 | 17 4 | 3 04 | 16/16 |
| Example 12 | NiCr | Cr | 10 | 8 5 | Performed | Ferric Chloride | 12 0 | 16 5 | 3 78 | 16/16 |

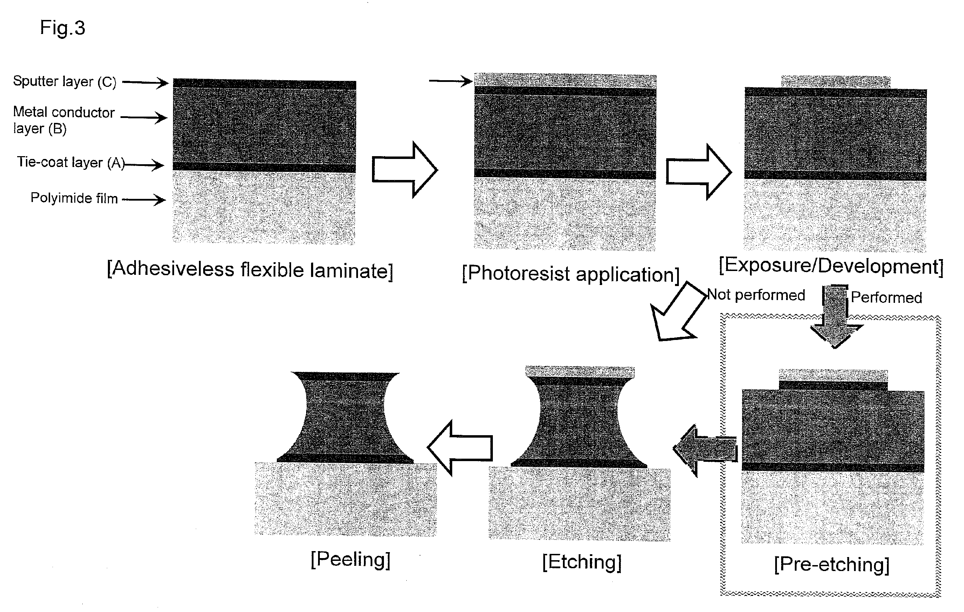

Fig. 3 is a process chart of the etching performed in the Examples. As shown, the processes performed to the adhesiveless flexible laminate were application and exposure/development of the photoresist, pre-etching of the sputter layer, etching of the metal conductive layer, and peeling of the photoresist layer.

### (Comparative Example 1)

Comparative Example 1 is a case of forming a conductor layer B having a copper thickness of 8.5 micrometers without forming a tie-coat layer A, and without a sputter layer C. Pre-etching was not performed, and etching was performed using ferric chloride.
The top width of the circuit after etching was 11.3 µm, the bottom width was 21.4 µm, and the etch factor was inferior at 1.69. Note that 16 out of 16 (16/16) circuits were free of disarray, and the linearity of the circuit was favorable.

### (Comparative Example 2)

Comparative Example 2 is a case where the ferric chloride of Comparative Example 1 was changed to copper chloride. The top width of the circuit after etching was 11.3 µm, the bottom width was 20.5 µm, and the etch factor was inferior at 1.85. Note that 16 out of 16 (16/16) circuits were free of disarray, and the linearity of the circuit was favorable. In both cases, when there is no sputter layer C, there was hardly any difference in the etch factor even when a different etching solution was used.

### (Comparative Example 3)

Comparative Example 3 is a case where a tie-coat layer A made of nickel alloy (Ni/Cr = 80/20) having a thickness of 10 nm was formed on the polyimide film, a conductor layer B having a copper thickness of 8.5 micrometers was formed thereon, and a sputter layer C made of nickel alloy (Ni/Cr = 80/20) having a thickness of 10 nm was formed thereon. Note that all alloy compositions are shown as mass percent, and, as the indication of alloy, for instance, an alloy containing 80 mass percent of nickel and 20 mass percent of chromium is indicated as "Ni/Cr = 80/20". Pre-etching was not performed, and etching was performed using ferric chloride. The top width of the circuit after etching was 11.2 µm, the bottom width was 16.8 µm, and the etch factor increased and was favorable at 3.04. Nevertheless, 8 out of 16 (8/16) circuits were subject to disarray, and a phenomenon where the linearity of the circuit deteriorated was observed.

### (Comparative Example 4)

Comparative Example 4 is a case where the ferric chloride of Comparative Example 3 was changed to copper chloride. The top width of the circuit after etching was 11.1 µm, the bottom width was 16.7 µm, and the widths were favorable. Nevertheless, as with Comparative Example 3, 7 out of 16 (9/16) circuits were subject to disarray, and a phenomenon where the linearity of the circuit deteriorated was observed. Based on Comparative Example 3 and Comparative Example 4, it was confirmed that there is hardly any difference in the etch factor even when a different etching solution is used.

### (Comparative Example 5)

Comparative Example 5 is a case where a tie-coat layer A made of nickel alloy (Ni/Cr = 80/20) having a thickness of 30 nm was formed on the polyimide film, a conductor layer B having a copper thickness of 8.5 micrometers was formed thereon, and a sputter layer C made of nickel alloy (Ni/Cr = 80/20) having a thickness of 30 nm was formed thereon. Pre-etching was not performed, and etching was performed using ferric chloride.
With this Comparative Example 5, even more time was required for the dissolution and peeling of the sputter layer, and the dissolution of the copper layer had already advanced at the point in time that the sputter layer was removed. Thus, it was determined that a circuit cannot be formed (linearity of the circuit was evaluated as 0) since a phenomenon in which the circuit flows was observed. Thus, the test was discontinued at this point, and the subsequent process (measurement of etch factor) was not performed.

### (Comparative Example 6)

Comparative Example 6 is a case where a tie-coat layer A made of nickel having a thickness of 10 nm and a sputter layer C having a thickness of 10 nm made of the same nickel were formed in substitute for the nickel alloy (Ni/Cr = 80/20) of Comparative Example 3. Pre-etching was not performed, and etching was performed using ferric chloride.
The top width of the circuit after etching was 11.5 µm, the bottom width was 17.2 µm, and the etch factor increased and was favorable at 2.98. Nevertheless, 9 out of 16 (7/16) circuits were subject to disarray, and a phenomenon where the linearity of the circuit deteriorated was observed.

### (Comparative Example 7)

Comparative Example 7 is a case where the tie-coat layer A and the sputter layer C of Comparative Example 6 were formed to have a thickness of 30 nm, but it was not possible to form a circuit as with Comparative Example 5.

### (Comparative Example 8)

Comparative Example 8 is a case where a tie-coat layer A made of chromium having a thickness of 10 nm and a sputter layer C having a thickness of 10 nm made of the same chromium were formed in substitute for the nickel alloy (Ni/Cr = 80/20) of Comparative Example 3. Since chromium hardly dissolves in ferric chloride, it was not possible to form a circuit.

### (Comparative Example 9)

Comparative Example 9 is a case where cobalt alloy (Co/Cr = 80/20) was used in substitute for the nickel alloy (Ni/Cr = 80/20) of Comparative Example 4. The top width of the circuit after etching was 11.3 µm, the bottom width was 17.0 µm, and the etch factor was favorable at 2.98. Nevertheless, as with Comparative Example 4, 6 out of 16 (10/16) circuits were subject to disarray.

### (Comparative Example 10)

Comparative Example 10 is a case where the thickness of the conductor layer (copper thickness) B of Comparative Example 3 was set to 12 micrometers. Due to the influence of the increased copper thickness, the etch factor decreased to 1.93, and 14 out of 16 circuits (2/16) were subject to disarray.

In the particular samples to which pre-etching was not performed as in Comparative Example 3 to Comparative Example 10 were affected by the thickness of the sputter layer C, there were problems in the circuit formation itself, and in certain cases it was not even possible to calculate the etch factor.

### (Example 1)

Example 1 is a case of forming a tie-coat layer A made of nickel alloy (Ni/Cr = 80/20) having a thickness of 3 nm on a polyimide film, forming a conductor layer B having a copper thickness of 8.5 micrometers thereon, and additionally forming a sputter layer C having a thickness of 3 nm thereon. Pre-etching was not performed, and etching was performed using ferric chloride.
The top width of the circuit after etching was 11.9 µm, the bottom width was 17.7 µm, the etch factor increased to 2.93, and favorable etching properties were obtained. Moreover, 16 out of 16 circuits (16/16) were free of disarray, and the linearity of the circuit was also favorable.

### (Example 2)

Example 2 is a case of forming a tie-coat layer A made of nickel alloy (Ni/Cr = 80/20) having a thickness of 30 nm on a polyimide film, forming a conductor layer B having a copper thickness of 8.5 micrometers thereon, and additionally forming a sputter layer C made of nickel alloy (Ni/Cr = 80/20) having a thickness of 30 nm thereon. Pre-etching was performed, and etching was further performed using copper chloride.
The top width of the circuit after etching was 12.7 µm, the bottom width was 15.3 µm, the etch factor increased to 6.54, and favorable etching properties were obtained. Moreover, 16 out of 16 circuits (16/16) were free of disarray, and the linearity of the circuit was also favorable.

### (Example 3)

Example 3 is a case of setting the thickness of the tie-coat layer A and sputter layer C made of nickel alloy (Ni/Cr = 80/20) of Example 2 to 50 nm.
The top width of the circuit after etching was 12.5 µm, the bottom width was 15.8 µm, the etch factor was high at 5.15, and favorable etching properties were obtained. Moreover, 16 out of 16 circuits (16/16) were free of disarray, and the linearity of the circuit was also favorable.

### (Example 4)

Example 4 is a case of forming a tie-coat layer A made of nickel having a thickness of 10 nm on a polyimide film, forming a conductor layer B having a copper thickness of 8.5 micrometers thereon, and additionally forming a sputter layer C made of nickel having a thickness of 10 nm thereon. Pre-etching was performed, and etching was further performed using ferric chloride.
The top width of the circuit after etching was 12.0 µm, the bottom width was 17.2 µm, the etch factor was high at 3.27, and favorable etching properties were obtained. Moreover, 16 out of 16 circuits (16/16) were free of disarray, and the linearity of the circuit was also favorable.

### (Example 5)

Example 5 is a case of forming a tie-coat layer A made of chromium having a thickness of 10 nm on a polyimide film, forming a conductor layer B having a copper thickness of 8.5 micrometers thereon, and additionally forming a sputter layer C made of chromium having a thickness of 10 nm thereon. Pre-etching was performed, and etching was further performed using ferric chloride.
The top width of the circuit after etching was 12.5 µm, the bottom width was 16.0 µm, and the etch factor was high and favorable at 4.86. Moreover, 16 out of 16 circuits (16/16) were free of disarray, and the linearity of the circuit was also favorable.

### (Example 6)

Example 6 is a case where the thickness of the chromium sputter layer C of Example 5 was set to 20 nm, and the etch factor was favorable at 5.15. This shows that even with a sputter layer C that is insoluble in ferric chloride, an effect of being able to increase the etch factor is yielded by selectively etching and removing the sputter layer C in the pre-etching process.

### (Example 7)

Example 7 is a case of forming a tie-coat layer A made of cobalt having a thickness of 10 nm on a polyimide film, forming a conductor layer B having a copper thickness of 8.5 micrometers thereon, and additionally forming a sputter layer C made of cobalt having a thickness of 10 nm thereon. Pre-etching was not performed, and etching was performed using copper chloride.
The top width of the circuit after etching was 11.1 µm, the bottom width was 17.5 µm, and the etch factor was high and favorable at 2.66. Moreover, 16 out of 16 circuits (16/16) were free of disarray, and the linearity of the circuit was also favorable.
Since cobalt easily dissolves in an etching solution in comparison to nickel alloy (Ni/Cr = 80/20), circuit formation was possible even with the same thickness of 10 nm, and the linearity was also favorable.

### (Example 8)

Example 8 is a case where pre-etching was further performed under the conditions of Example 7, and the etch factor was 2.98 and an etch factor that is even more favorable than Example 7 was obtained.

### (Example 9)

Example 9 is a case of forming a tie-coat layer A made of cobalt chromium (CoCr) having a thickness of 10 nm on a polyimide film, forming a conductor layer B having a copper thickness of 8.5 micrometers thereon, and additionally forming a sputter layer C made of cobalt chromium (CoCr) having a thickness of 10 nm thereon. Pre-etching was performed, and etching was performed using copper chloride.
The top width of the circuit after etching was 11.5 µm, the bottom width was 16.9 µm, and the etch factor was high and favorable at 3.15. Moreover, 16 out of 16 circuits (16/16) were free of disarray, and the linearity of the circuit was also favorable.

### (Example 10)

Example 10 is a case of forming a tie-coat layer A made of nickel alloy (Ni/Cr = 80/20) having a thickness of 10 nm on a polyimide film, forming a conductor layer B having a copper thickness of 12 micrometers thereon, and additionally forming a sputter layer C made of nickel alloy (Ni/Cr = 80/20) having a thickness of 10 nm thereon.
Pre-etching was performed, and etching was further performed. The top width of the circuit after etching was 12.2 µm, the bottom width was 20.2 µm, and the etch factor was high and favorable at 2.13. Moreover, 16 out of 16 circuits (16/16) were free of disarray, and the linearity of the circuit was also favorable.

### (Example 11)

Example 11 is a case where the tie-coat layer A of Example 4 was made of nickel alloy (Ni/Cr = 80/20), and different layers were formed below and above the metal conductive layer B.
The tie-coat layer A was nickel alloy and the sputter layer C was nickel. Here, pre-etching and the subsequent etching could be advanced as with the case where the layers below and above the metal conductive layer B are the same. The top width of the circuit after etching was 11.8 µm, the bottom width was 17.4 µm, and the etch factor was high and favorable at 3.04. Moreover, 16 out of 16 circuits (16/16) were free of disarray, and the linearity of the circuit was also favorable.

### (Example 12)

Example 12 is a case where the tie-coat layer A of Example 5 was made of nickel alloy (Ni/Cr = 80/20) and the sputter layer was made of a chromium layer, and different layers were formed below and above the metal conductive layer B.
The tie-coat layer A was nickel alloy and the sputter layer C was chromium. Here, pre-etching and the subsequent etching could be advanced as with the case where the layers below and above the metal conductive layer B are the same. The top width of the circuit after etching was 12.0 µm, the bottom width was 16.5 µm, and the etch factor was high and favorable at 3.78. Moreover, 16 out of 16 circuits (16/16) were free of disarray, and the linearity of the circuit was also favorable.

Fig. 4 is a photograph showing a state of the circuit when the circuit was formed via the etching process of Comparative Example 1. As shown, it can be seen that the width between the circuits is narrow due to the sagging.
Fig. 5 is a photograph showing a state of the circuit of Comparative Example 3 when the circuit was not subject to pre-etching. As shown, it can be seen that the linearity of the circuit is inferior and the width of the circuit is subject to disarray.
Fig. 6 is a diagram showing the case of Example 2 of the present invention in which the sputter layer C was subject to pre-etching. It can be seen that the width between the circuits is wide and the linearity of the circuit is favorable since there is no sagging.

While the etch factor will increase as the thickness of the sputter layer C on the metal conductor layer B is thicker, the sputter layer will remain as shown in Fig. 3 after the photoresist is peeled. Nevertheless, this is ultimately removed in the end.
Generally speaking, when forming a fine pattern circuit demanded of long-term electrical reliability such as migration resistance properties, the selective etching of the tie-coat layer A is introduced as post-etching in order to remove the residue of the tie-coat layer after forming the circuit with ferric chloride or copper chloride. The same can be applied in the present invention.

Moreover, the sputter layer C can be removed by the foregoing post-etching, and there is no need to newly install a special removal line. Nevertheless, since the removal process of the sputter layer C is required, simply increasing the thickness is not necessarily advisable. The thickness of the sputter layer can be changed as needed and desirable thickness of the sputter layer C is generally 1 to 50 nm in consideration of economic efficiency of its removal process and the etching properties.

The present invention resolves the foregoing problems by forming, on the metal conductor layer B, a metal or alloy layer made of the same components as the tie-coat layer A of the adhesiveless flexible laminate, and thereby simultaneously inhibiting the side etching which interferes with the achievement of finer pitches of circuit wiring.
A superior effect is yielded in that the linearity of the wiring can be improved by removing in advance the sputter layer C formed immediately above the metal conductor layer B to be etched, prior to etching the metal conductor layer B. The effectiveness of the present invention can be confirmed from the foregoing facts.

### INDUSTRIAL APPLICABILITY

The adhesiveless flexible laminate of the present invention in which a tie-coat layer or an equivalent layer C; specifically, a layer selected from one type among nickel, chromium, cobalt, nickel alloy, chromium alloy, and cobalt alloy is formed above and under a metal conductor layer B yields a superior effect. The effect, on the tie-coat layer A side is of being able to improve the adhesion between the polyimide film and the metal layer after thermal aging, whereas on the upper surface side of the metal conductor layer, is of being able to inhibit the side etching when forming a circuit, thus to achieve a high etch factor.

Consequently, when forming a circuit by etching the metal conductor layer B of the flexible laminate substrate based on the foregoing configuration, it is possible to prevent the occurrence of sagging caused by the etching process, and shorten the time required for forming a circuit via etching. In addition, prior to etching the metal conductor layer B, by removing in advance the metal layer, which has a lower etching rate than that of copper, formed immediately above the metal conductor layer B to be etched; specifically, the tie-coat layer A or the equivalent layer (sputter layer) C, a superior effect is yielded in that the linearity of the wiring can be improved.
Accordingly, the present invention yields an effect of being able to provide an adhesiveless flexible laminate for use in electronic circuits in which a circuit with an even more uniform intended circuit width can be formed, etching properties in pattern etching can be improved, and occurrence of short circuits and defective circuit widths can be prevented. Thus, the present invention is useful as a flexible laminate for use as a packaging material for electronic parts such as flexible printed boards, TAB and COF.

## Claims

1. A method of forming a circuit on a flexible laminate substrate, wherein, when forming a circuit using an adhesiveless flexible laminate which includes a polyimide film as the flexible laminate substrate in which at least one surface thereof is subject to plasma treatment, a tie-coat layer A formed on the polyimide film, a metal conductor layer B formed on the tie-coat layer, and a metal or alloy layer C, which has a lower etching rate than that of copper, formed on the metal conductor layer, photoresist is coated on the metal or alloy layer C, which has a lower etching rate than that of copper, formed on the metal conductor layer, the photoresist is exposed and developed, the layer C other than the circuit forming parts thereof is selectively removed in advance via pre-etching, the conductor layer B is thereafter removed by supplemental etching with leaving the circuit portion, and the photoresist of the circuit portion is further removed so as to form the circuit.

2. The method of forming a circuit on a flexible laminate substrate according to claim 1, wherein the layer C formed on the metal conductor layer is a sputter layer selected from one type among nickel, chromium, cobalt, nickel alloy, chromium alloy, and cobalt alloy having a thickness of 1 to 50 nm.

3. The method of forming a circuit on a flexible laminate substrate according to claim 1 or claim 2, wherein the layer C formed on the metal conductor layer has the same components as the tie-coat layer A.

4. The method of forming a circuit on a flexible laminate substrate according to any one of claims 1 to 3, wherein the tie-coat layer A is a sputter layer selected from one type among nickel, chromium, cobalt, nickel alloy, chromium alloy, and cobalt alloy having a thickness of 5 to 100 nm.

5. The method of forming a circuit on a flexible laminate substrate according to any one of claims 1 to 4, wherein the metal conductor layer B is copper or copper alloy.
